# FASCICULE DE BREVET EUROPEEN

(11) **EP 1 082 812 B1**
(45) Date de publication et mention de la délivrance du brevet: **13.03.2002**
(21) Numéro de dépôt: 99920943.0
(22) Date de dépôt: 28.05.1999
(51) Int. Cl.: H03H 9/145

(54) **TRANSDUCTEUR A ONDES ACOUSTIQUES DE SURFACE A FAIBLE GAP**
ENGSPALTIGER AKUSTISCHER OBERFLÄCHENWELLENWANDLER
TRANSDUCER WITH SURFACE ACOUSTIC WAVES WITH LOW GAP

(30) Priorité: 29.05.1998 FR 9806835
(43) Date de publication de la demande: 14.03.2001
(73) Titulaire: Thales, 75008 Paris (FR)
(72) Inventeur: WRIGHT, Peter, Thomson-CSF Prop. Int. Dépt. Brev., 94117 Arcueil Cédex (FR)
(86) Numéro de dépôt international: FR9901266
(87) Numéro de publication internationale: WO9963663

(56) Documents cités:
- WO-A-82/01629
- US-A- 5 162 689
- HINES J H ET AL: "HIGH FREQUENCY SAW DEVICES" 1997 IEEE MTT-S INTERNATIONAL MICROWAVE SYMPOSIUM DIGEST, DENVER, JUNE 8 - 13, 1997, vol. 1, 8 juin 1997 (1997-06-08), pages 177-180, XP000767185 INSTITUTE OF ELECTRICAL AND ELECTRONICS ENGINEERSISBN: 0-7803-3815-4

## Description

Le domaine de l'invention est celui des transducteurs à ondes acoustiques de surface fonctionnant à très hautes fréquences typiquement à des fréquences de l'ordre de plusieurs GigaHertz.

De manière conventionnelle, les transducteurs sont typiquement fabriqués en utilisant des structures de deux, quatre ou huit électrodes par longueur d'onde λ, λ correspondant à la fréquence centrale de fonctionnement du transducteur, selon les applications visées (transducteur avec ou sans réflexion). Dans toutes ces types de transducteurs, le ratio généralement utilisé entre les surfaces métallisées au niveau du substrat et les surfaces libres est typiquement compris entre 0,25 et 0,75.

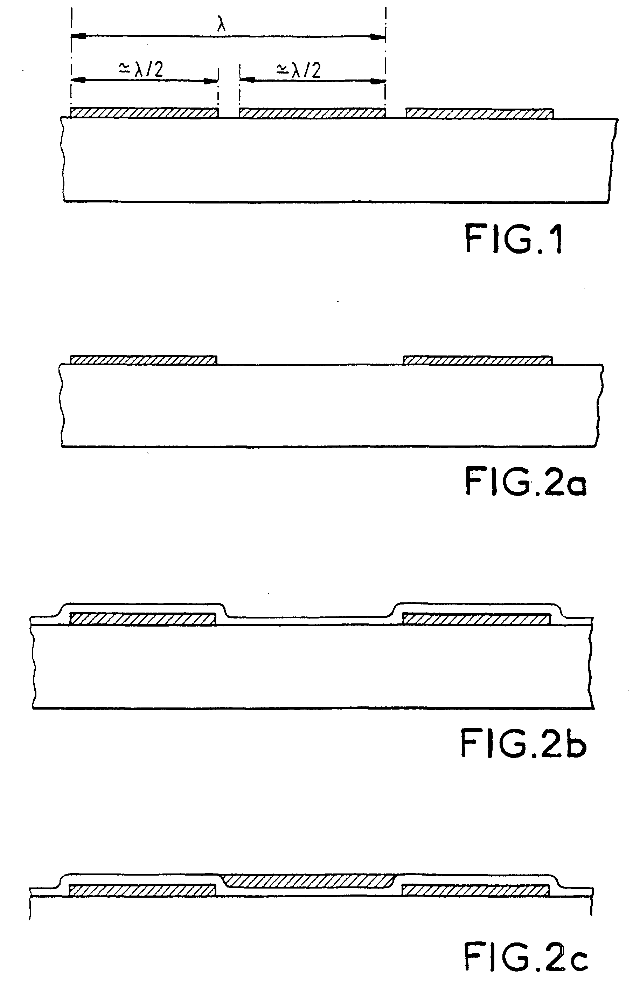

Une nouvelle classe de transducteurs a désormais vu le jour. Il s'agit de transducteurs dits à faible gap dans lesquels la surface libre est très réduite de manière à obtenir la plus petite distance possible entre deux électrodes consécutives comme illustré en figure 1. Les avantages de ce type de transducteur résident dans le fait que l'on peut obtenir des largeurs d'électrodes les plus grandes possibles, par période avec donc des phénomènes de réflexions entre électrodes fortement diminués. L'inconvénient de ces structures résident dans les difficultés technologies. A titre d'exemple, pour un transducteur fonctionnant à 16 GHz, des électrodes de largeur λ/2 soit 1,5 µm doivent être séparées de distance de l'ordre de quelques centaines d'Angströms, ce qui nécessite une technologie délicate. Différentes technologies ont été proposées et notamment celle proposée par J.H. Hines et D.C. Malocha « 1997, IEEE MTT-S International Microwave Symposium Digest (Cat. N° 97CH3607), Denvers, CO, USA, 8-13 June 1993 ». Selon ce concept, on procède à la réalisation classique d'électrodes selon le ratio métallisation/surface libre de l'ordre de 50/50, comme illustré en figure 2a. L'ensemble de cette première série d'électrodes est recouvert d'une couche de matériau diélectrique (figure 2b). On procède alors à la réalisation d'une deuxième série d'électrodes comme illustré en figure 2c. Il est ainsi possible d'obtenir des électrodes séparées par une très faible distance correspondant à l'épaisseur de la couche de matériau diélectrique, néanmoins la deuxième série d'électrodes n'est pas en contact direct diélectrique avec le substrat piézoélectrique et génère ainsi un couplage de moins bonne efficacité.

De plus, cette technologie conduit de manière inhérente à des structures sans réflexion possible et donc nécessairement à des transducteurs bidirectionnels.

Dans ce contexte, l'invention propose un nouveau type de transducteur de type transducteur à faible gap, pouvant être obtenu par une technologie simple et conduisant à des transducteurs ne présentant pas de problème de couplage. Selon l'invention le gap entre électrodes consécutives est obtenu dans une direction perpendiculaire au plan du substrat et grâce à la présence d'une réseau de gravure.

Plus précisément, l'invention a pour objet un transducteur à ondes acoustiques de surface fonctionnant à des fréquences de l'ordre de quelques Gigahertz et comportant un substrat sur lequel sont déposés au moins deux réseaux d'électrodes interdigitées et connectés à des polarités différentes, de manière à créer des cellules de transduction acoustique, définies par au moins deux électrodes consécutives de polarités différentes, caractérisé en ce qu'il comprend :
- un réseau de gravures séparées par des mesa, dans le substrat;
- I'ensemble des mesa et des gravures étant intégralement recouvert d'une couche de métallisation constitutive des électrodes ;
- la profondeur des gravures étant supérieure à l'épaisseur de la couche de métallisation de manière à créer un gap de l'ordre de quelques centaines d'Angströms dans une direction perpendiculaire au plan du substrat, entre eux électrodes consécutives.

Ce type de transducteur présente l'intérêt d'être réalisable de manière directe. En effet, après avoir réalisé dans un premier temps un réseau de gravure présentant la périodicité voulue, il suffit dans un second temps de procéder à la métallisation de l'ensemble de la surface du réseau gravé.

Il est à noter que pour minimiser la sensibilité à la production, il peut être intéressant de réaliser des mesa plus larges que les gravures.

Avantageusement, le transducteur à faible gap selon l'invention peut présenter une direction privilégiée de propagation des ondes acoustiques.

Il est à noter que dans l'art connu il a déjà été proposé de réaliser des architectures de transducteur, utilisant des mesa et des gravures (WO 82/01629) mais visant.d'autres domaines d'application / transducteurs fonctionnant à des mégahertz, avec des gap- beaucoup plus grands et des métallisations non continues entre mesa et gravures.

C'est ainsi que selon une première variante de l'invention, la distance entre deux électrodes consécutives est égale à λ/4, et est également égale à la distance entre une mesa et une gravure consécutives. Les flancs de gravure créent des réflexions qui permettent la remise en phase des ondes émises avec les ondes réfléchies dans une direction privilégiée et l'opposition de phase dans la direction opposée de manière à obtenir un transducteur unidirectionnelle encore dénommé SPUDT dans la littérature (Single-Phase Unidirectional Transducteurs). Dans ce type de transducteur, il a par ailleurs été démontré qu'il pouvait être intéressant de réaliser des cavités résonantes à l'intérieur dudit transducteur, ceci est notamment décrit dans la demande de brevet publiée 2 702 899. Pour créer une cavité résonante, il est nécessaire de localement modifier la directivité des ondes acoustiques de surface. Pour cela, de manière classique, on joue sur la phase, en déplaçant localement une électrode, ce qui n'est pas direct d'un point de vue technologique.

Selon l'invention, il devient très simple de changer la directivité, en réalisant localement une gravure d'une dimension plus grande typiquement deux fois plus grande.

Selon une seconde variante de l'invention, le transducteur à faible gap est un transducteur bidirectionnel présentant une période de λ/2. Ce type de transducteur possède de manière générale un très bon coefficient de couplage et une dimension critique en technologie en λ/2 donc de réalisation plus aisée que les transducteurs ayant une configuration de 4 électrodes par λ.

Selon une troisième variante de l'invention, le transducteur à faible gap comprend des gravures et des mesa de période λ/3. Ce type de transducteur présente l'avantage de minimiser fortement les réflexions nettes d'électrodes, objectif recherché dans certaines applications.

L'invention sera mieux comprise et d'autres avantages apparaîtront à la lecture de la description qui va suivre donnée à titre non limitatif et grâce aux figures annexées parmi lesquelles :
- la figure 1 illustre un transducteur à faible gap selon l'art connu ;
- les figures 2a à 2c illustrent les différents étapes d'un procédé de l'art connu pour réaliser un transducteur à faible gap ;
- la figure 3a illustre un premier exemple de transducteur à faible gap selon l'invention, présentant une direction privilégiée de propagation des ondes acoustiques ;
- la figure 3b illustre un deuxième exemple de transducteur à faible gap selon l'invention présentant une direction privilégiée de propagation des ondes, opposée à celle de l'exemple de la figure 3a ;
- la figure 3c illustre un troisième exemple de transducteur à faible gap selon l'invention présentant un changement local de direction privilégiée des ondes acoustiques ;
- la figure 4 illustre un quatrième exemple de transducteur à faible gap comprenant des largeurs de mesa et de gravures différentes ;
- la figure 5 illustre un cinquième exemple de transducteur à faible gap, selon l'invention présentant une période en λ/2 et étant bidirectionnel ;
- la figure 6 illustre un sixième exemple de transducteur à faible gap, selon l'invention, étant bidirectionnel et dont la réflectivité est ajustée par la période du réseau de gravure ;
- la figure 7 illustre un septième exemple de transducteur à faible gap, selon l'invention, étant bidirectionnel et de type 3 électrodes par λ;
- la figure 8 illustre un huitième exemple de transducteur à faible gap selon l'invention, étant unidirectionnel, de type 3 électrodes par λ.

De manière générale, les transducteurs à ondes de surface, selon l'invention, comprennent un substrat pouvant être de type quartz, gravé dans un premier temps puis métallisé dans un second temps, par un métal de type aluminium. Les substrats utilisés peuvent avantageusement être du type LiNbO₃, LiTaO₃ ou bien encore Li₂B₄O₇. Actuellement, il existe des techniques de gravure, bien maîtrisées sur des substrats de type quartz et notamment la technique dite ICP (Inductive Coupled Plasma) utilisant un plasma haute énergie et permettant la fabrication en série et à bas coût de dispositifs gravés.

Selon une première variante de l'invention, le transducteur à faible gap possède une direction privilégiée de propagation des ondes acoustiques de surface conférée par une configuration comprenant 4 électrodes par longueur d'onde λ, avec des centres de réflexion situés à une distance de λ/8 par rapport à des centres de transduction.

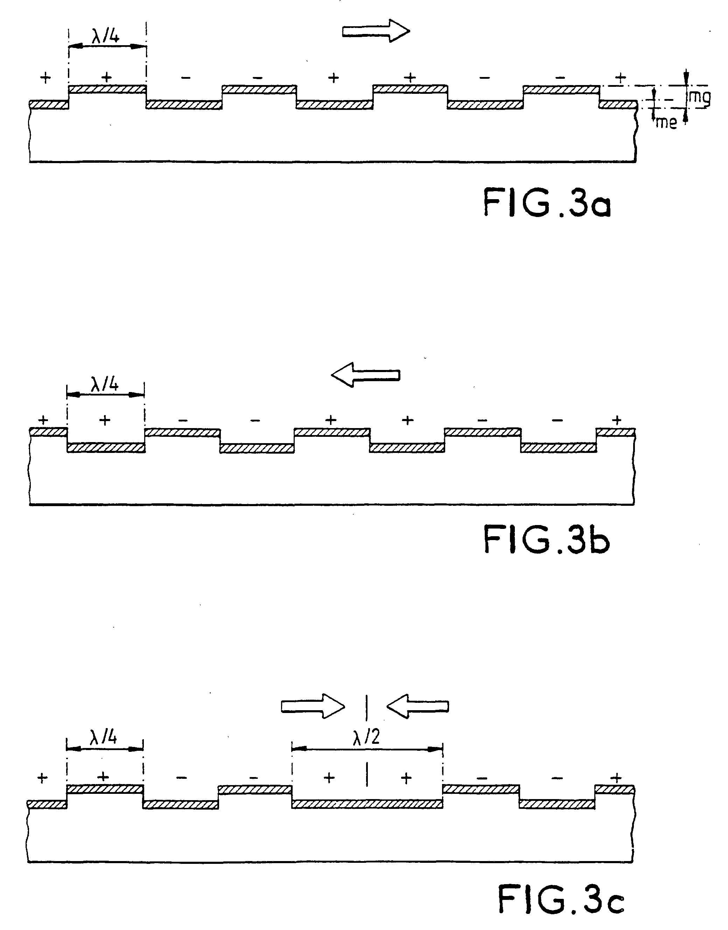

Selon l'exemple décrit en figure 3a, les électrodes déposées à la surface des mesa et des gravures présentent une largeur de λ/4. Deux réseaux d'électrodes présentent des paires d'électrodes référencées par des signes + et - sur la figure 3a, de manière à créer des centres de transduction acoustique et des centres de réflexion tels qu'il y ait remise en phase des ondes émises avec des ondes réfléchies.

Dans toutes les configurations de l'invention, il est essentiel que l'épaisseur de métallisation mₑ soit inférieure à la profondeur de gravure m_{g} comme illustré en figure 3a.

Selon un autre exemple de l'invention illustré en figure 3b, il est possible d'inverser la direction de propagation des ondes acoustiques en inversant les mesa et les gravures par rapport à la configuration décrite en figure 3a.

De même que dans l'art connu et notamment décrit dans la demande de brevet publiée sous le n° 2 702 899, déposée par la demanderesse, il peut être intéressant de retourner localement la directivité des ondes de surface de manière à créer des cavités résonantes comme l'illustre la figure 3c. Pour cela, il suffit localement à l'aide du masque de gravure employé lors de l'opération de gravure du substrat, de créer une gravure présentant une largeur double de λ/2.

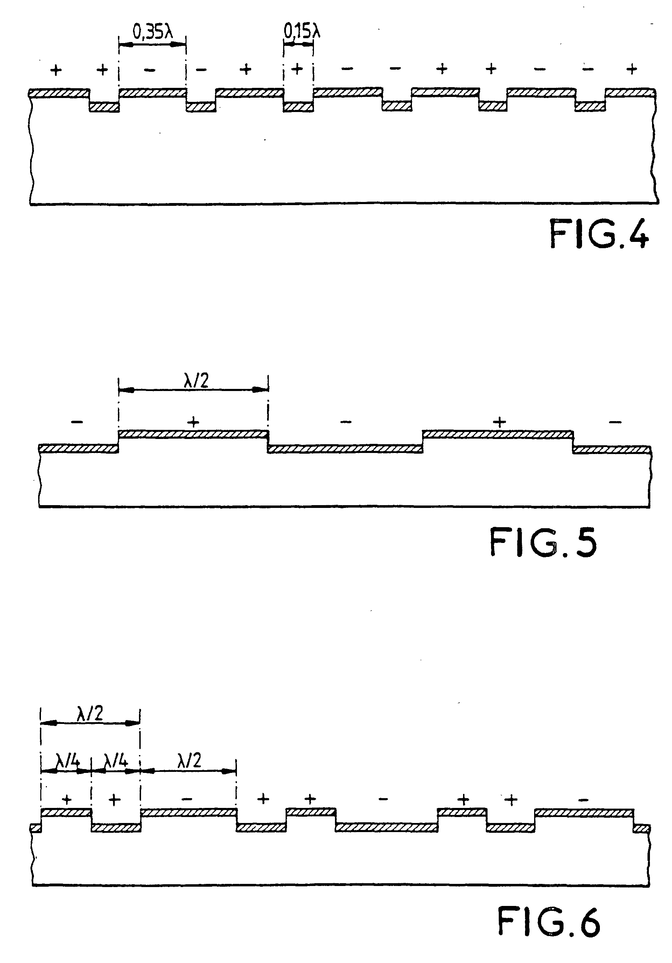

La figure 4 illustre une variante de ce type de transducteur unidirectionnel, dans lequel la période des mesa ou de gravures est égale à λ/4. D'un point de vue technologique il peut être intéressant de réaliser des mesa de largeur plus élevée que celle des gravures tout en conservant la périodicité voulue. Selon l'exemple illustré en figure 4, la largeur d'une mesa peut typiquement être de l'ordre de 0,35 λ, alors que la largeur d'une gravure est typiquement de l'ordre de 0,15 λ.

Les transducteurs unidirectionnels qui viennent d'être décrits présentent de très bonnes performances de couplage. En effet, généralement les transducteurs unidirectionnels doivent posséder dans leur séquence d'électrodes une asymétrie responsable de l'unidirectionnalité (au dépend d'une direction bidirectionnelle assurée par une structure parfaitement symétrique). Cependant, cette direction privilégiée est obtenue au prix d'un coefficient de couplage moins satisfaisant.

Selon la configuration proposée dans l'invention, le transducteur à ondes de surface conserve une symétrie parfaite d'électrodes, l'asymétrie nécessaire pour créer la direction privilégiée de propagation des ondes, est créée grâce à la présence du réseau de gravure. Les réflexions nettes des électrodes sont symétriques les unes par rapport aux autres et ne créent pas de direction privilégiée, alors que les flancs de gravure font apparaître des réflexions qui ne se compensent pas entre une direction donnée et la direction opposée. L'invention permet ainsi d'obtenir des transducteurs unidirectionnels à faible gap, alors que les transducteurs à faible gap de l'art antérieur sont uniquement bidirectionnels, avec de fortes réflexions nettes d'électrodes.

Selon une seconde variante de l'invention, le transducteur à ondes de surface à faible gap, peut présenter une configuration de deux électrodes par longueur d'onde λ. De tels transducteurs sont bidirectionnels et présentent d'excellents coefficients de couplage par rapport aux autres types de transducteurs et notamment les transducteurs unidirectionnels à 4 électrodes par λ.

L'implantation d'électrodes de ce type de structure est illustrée en figure 5. Dans cette structure les flancs de gravure n'introduisent pas comme précédemment des réflexions permettant de créer l'unidirectionnalité mais sont présents uniquement pour créer le gap entre deux électrodes consécutives. L'amplitude du coefficient de réflexion des électrodes peut être avantageusement ajusté en fonction de la profondeur de gravure, tout en maintenant une faible épaisseur de métallisation.

De manière générale, les structures de transducteurs à deux électrodes par λ, sont choisies pour des applications de résonateurs en raison des fortes réflexions créées par les électrodes qui permettent de faire résonner efficacement les ondes de surface, en raison de la mise en phase des ondes émises et réfléchies (distance de λ/2 entre deux centres d'électrodes consécutives). Dans certaines applications, on peut être amené à ajuster le caractère résonant de ce type de structure tout en conservant le très bon coefficient de couplage conférée par les structures à 2 électrodes par λ.

Selon l'invention et grâce à la superposition de réseaux d'électrodes et d'un réseau de gravure, cela est possible en positionnant certaines électrodes à cheval sur une mesa et une gravure comme illustré en figure 6. Les électrodes présentent toujours une largeur de λ/2, mais certaines électrodes présentent un coefficient de réflexion modifié, dans lequel intervient une contribution de réflexion d'électrode et une contribution de réflexion de flanc de gravure. Ces contributions tendent à s'opposer pour diminuer le coefficient global de réflexion de certaines électrodes et ainsi amoindrir les phénomènes de réflexion nette des électrodes, très importants de manière générale dans ce type de transducteur.

Nous venons de décrire certains types de transducteurs (4 électrodes par λ, 2 électrodes par λ), il est à noter que de manière générale, l'invention peut s'appliquer à tout type de transducteur, faisant appel à une technologie qui permet une grande latitude au niveau des largeurs d'électrodes (elles peuvent tout aussi bien être de dimension λ/3), en conservant le caractère de faible gap toujours gouverner la profondeur de gravure.

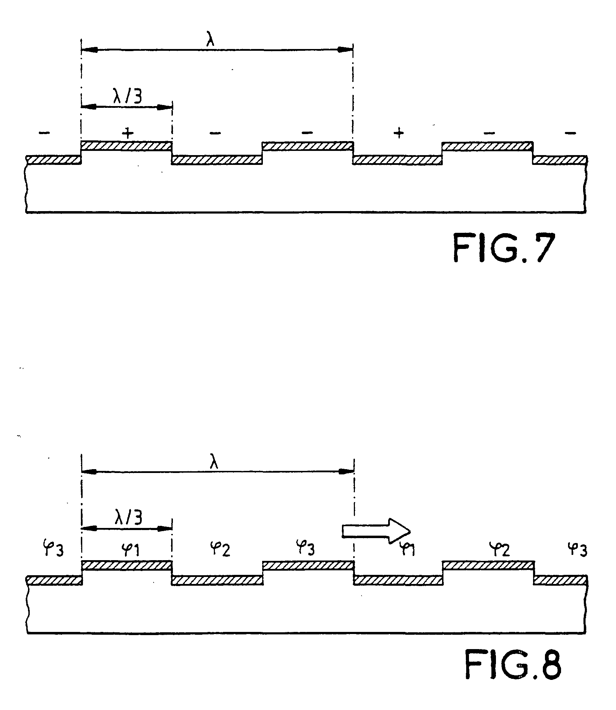

Plus précisément, nous allons décrire des transducteurs selon l'invention, à faible gap et présentant des périodes d'électrodes et de mesa égale à λ/3. Avec ce type de configuration, on parvient à minimiser les réflexions nettes. La figure 7 illustre un exemple de ce type de transducteur ; il s'agit d'un transducteur bidirectionnel, comprenant deux réseaux d'électrodes connectés respectivement à une première et une seconde polarités repérées respectivement par les signes + et -. Sur une dimension égale à la longueur d'onde λ, le premier réseau comprend une première électrode, le second réseau comprend une seconde et une troisième électrodes.

Une variante de ce type de transducteur, est un transducteur toujours à 3 électrodes par λ, mais rendu unidirectionnel, en utilisant non plus deux réseaux d'électrodes, mais trois réseaux d'électrodes. La figure 8 illustre un tel transducteur dans lequel les trois polarités des trois réseaux d'électrodes sont respectivement référencés par les signes ϕ1, ϕ2 et ϕ3.

## Revendications

1. Transducteur à ondes acoustiques de surface fonctionnant à des fréquences de l'ordre de quelques Gigahertz et comportant un substrat sur lequel sont déposés au moins deux réseaux d'électrodes interdigitées et connectés à des polarités différentes, de manière à créer des cellules de transduction acoustique, définies par au moins deux électrodes consécutives de polarités différentes, **caractérisé en ce qu'**il comprend :
- un réseau de gravures séparées par des mesa, dans le substrat ;
- l'ensemble des mesa et des gravures étant intégralement recouvert d'une couche de métallisation constitutive des électrodes;
- la profondeur des gravures étant supérieure à l'épaisseur de la couche de métallisation de manière à créer un gap de l'ordre de quelques centaines d'Angströms dans une direction perpendiculaire au plan du substrat, entre deux électrodes consécutives.

2. Transducteur à ondes acoustiques de surface selon la revendication 1, **caractérisé en ce que** les mesa et les gravures possèdent des largeurs différentes.

3. Transducteur à ondes acoustiques de surface selon l'une des revendications 1 ou 2, **caractérisé en ce qu'**il comprend des mesa et des gravures ayant des largeurs telles que la largeur totale d'une mesa et d'une gravure consécutive soit égale à une demi-longueur d'onde (λ/2), la longueur d'onde étant caractéristique de la fréquence de fonctionnement du transducteur, les réseaux d'électrodes interdigitées. comportant une alternance de paires d'électrodes, de manière à créer une direction privilégiée de propagation des ondes acoustiques.

4. Transducteur à ondes acoustiques de surface selon la revendication 2, **caractérisé en ce qu'**il comprend en outre au moins une mesa ou une gravure ayant une largeur égale à une demi-longueur d'onde caractéristique (λ/2), de manière à renverser localement la direction privilégiée de propagation des ondes acoustiques.

5. Transducteur à ondes acoustiques de surface selon l'une des revendications 1 ou 2, **caractérisé en ce qu'**il comprend des mesa et des gravures ayant des largeurs telles que la largeur totale d'une mesa et d'une gravure consécutives est égale à une longueur d'onde caractéristique.

6. Transducteur à ondes acoustiques de surface selon la revendication 5, **caractérisé en ce qu'**il comprend en outre des mesa et des gravures ayant une largeur égale à un quart de longueur d'onde (λ/4) de manière à réaliser des électrodes de largeur égale à une demi-longueur d'onde et positionnées à cheval sur une mesa et sur une gravure pour diminuer le coefficient de réflexion desdites électrodes.

7. Transducteur à ondes acoustiques de surface selon l'une des revendications 1 ou 2, **caractérisé en ce que** la période des gravures et des mesa est égale à un tiers de la longueur d'onde caractéristique de la fréquence de fonctionnement du transducteur.

8. Transducteur à ondes acoustiques de surface selon la revendication 7, **caractérisé en ce qu'**il comprend un premier et un second réseaux d'électrodes interdigitées tels que sur une dimension égale à la longueur d'onde caractéristique, le premier réseau comprenne une première électrode connectée à une première polarité, le second réseau comprenant une secondé et une troisième électrodes connectées à une seconde polarité.

9. Transducteur à ondes acoustiques de surface selon la revendication 7, **caractérisé en ce qu'**il comprend un premier, un second et un troisième réseaux d'électrodes interdigitées, connectés respectivement à une première, une seconde et une troisième polarités, tels que sur une dimension égale à la longueur d'onde caractéristique, le transducteur comprend une altemance d'une électrode du premier réseau, d'une électrode du second réseau et d'une électrode du troisième réseau.

## Claims

1. Surface acoustic wave transducer operating at frequencies of the order of a few gigahertz and comprising a substrate on which at least two interdigitated electrode arrays are deposited and connected to different polarities, so as to create acoustic transduction cells, which are defined by at least two consecutive electrodes of different polarities, **characterized in that** it comprises:
- a grating of etched grooves separated by mesas, in the substrate;
- all of the mesas and of the etched grooves being entirely covered with a metallization layer making up the electrodes;
- the depth of the etched grooves being greater than the thickness of the metallization layer so as to create a gap, of the order of a few hundred ångströms in a direction perpendicular to the plane of the substrate, between two consecutive electrodes.

2. Surface acoustic wave transducer according to Claim 1, **characterized in that** the mesas and the etched grooves have different widths.

3. Surface acoustic wave transducer according to either of Claims 1 and 2, **characterized in that** it comprises mesas and etched grooves having widths such that the total width of a mesa and of a consecutive etched groove is equal to a half-wavelength (λ/2), the wavelength being characteristic of the operating frequency of the transducer, the interdigitated electrode arrays comprising alternating electrode pairs, so as to create a favoured direction of propagation of the acoustic waves.

4. Surface acoustic wave transducer according to Claim 2, **characterized in that** it furthermore comprises at least one mesa or at least one etched groove having a width equal to a characteristic half-wavelength (λ/2), so as to locally reverse the favoured direction of propagation of the acoustic waves.

5. Surface acoustic wave transducer according to either of Claims 1 and 2, **characterized in that** it comprises mesas and etched grooves having widths such that the total width of a mesa and of a consecutive etched groove is equal to a characteristic wavelength.

6. Surface acoustic wave transducer according to Claim 5, **characterized in that** it furthermore comprises mesas and etched grooves having a width equal to a quarter-wavelength (λ/4), so as to make electrodes of width equal to a half-wavelength and positioned astride both a mesa and a groove in order to reduce the reflection coefficient of the said electrodes.

7. Surface acoustic wave transducer according to either of Claims 1 and 2, **characterized in that** the period of the etched grooves and of the mesas is equal to one third of the characteristic wavelength at the operating frequency of the transducer.

8. Surface acoustic wave transducer according to Claim 7, **characterized in that** it comprises a first and a second interdigitated electrode array, such that, over a length equal to the characteristic wavelength, the first array comprises a first electrode connected to a first polarity, the second array comprising a second and a third electrode, both connected to a second polarity.

9. Surface acoustic wave transducer according to Claim 7, **characterized in that** it comprises a first, a second and a third interdigitated electrode array, these being connected to a first, a second and a third polarity respectively, such that, over a length equal to the characteristic wavelength, the transducer comprises an alternation of one electrode from the first array, one electrode from the second array and one electrode from the third array.

## Patentansprüche

1. Wandler für akustische Oberflächenwellen, der im Bereich von einigen GHz betrieben wird und ein Substrat enthält, auf das mindestens zwei ineinander verschachtelte und an unterschiedliche Polaritäten angeschlossene Elektrodennetze aufgebracht sind, sodaß akustische Wandlerzellen entstehen, die durch mindestens zwei aufeinanderfolgende Elektroden unterschiedlicher Polaritäten definiert sind, **dadurch gekennzeichnet, daß**
- er ein Netz von durch mesaförmige Erhöhungen voneinander getrennten Vertiefungen im Substrat aufweist,
- die mesaförmigen Erhöhungen und Vertiefungen insgesamt von einer Metallschicht bedeckt sind, die Elektroden bildet,
- die Tiefe der Vertiefungen größer als die Dicke der Metallschicht ist, sodaß sich ein Spalt in der Größenordnung von einigen hundert Angström in einer Richtung senkrecht zur Ebene des Substrats zwischen zwei aufeinanderfolgenden Elektroden ergibt.

2. Akustischer Oberflächenwellenwandler nach Anspruch 1, **dadurch gekennzeichnet, daß** die mesaförmigen Erhöhungen und die Vertiefungen unterschiedlich breit sind.

3. Akustischer Oberflächenwellenwandler nach einem der Ansprüche 1 und 2, **dadurch gekennzeichnet, daß** er mesaförmige Erhöhungen und Vertiefungen einer solchen Breite besitzt, daß die Gesamtbreite einer Erhöhung und einer anschließenden Vertiefung einer halben Wellenlänge (λ/2) gleicht, wobei die Wellenlänge für die Betriebsfrequenz des Wandlers charakteristisch ist, und daß die ineinander verschachtelten Elektrodensätze einen Wechsel von Elektrodenpaaren derart aufweisen, daß sich eine bevorzugte Ausbreitungsrichtung der akustischen Wellen ergibt.

4. Akustischer Oberflächenwellenwandler nach Anspruch 2, **dadurch gekennzeichnet, daß** er außerdem mindestens eine mesaförmige Erhöhung oder eine Vertiefung einer Breite gleich einer halben charakteristischen Wellenlänge (λ/2) aufweist, sodaß die bevorzugte Ausbreitungsrichtung der akustischen Wellen lokal umgekehrt wird.

5. Akustischer Oberflächenwellenwandler nach einem der Ansprüche 1 und 2, **dadurch gekennzeichnet, daß** er mesaförmige Erhöhungen und Vertiefungen einer solchen Breite besitzt, daß die Gesamtbreite einer Erhöhung und einer anschließenden Vertiefung der charakteristischen Wellenlänge gleicht.

6. Akustischer Oberflächenwellenwandler nach Anspruch 5, **dadurch gekennzeichnet, daß** er außerdem Erhöhungen und Vertiefungen einer Breite gleich einer Viertelwellenlänge (λ/4) aufweist, sodaß sich Elektroden einer Breite gleich einer halben Wellenlänge ergeben, die sich teils auf einer Erhöhung und teils in einer Vertiefung befinden, um den Reflexionskoeffizienten der Elektroden zu verringern.

7. Akustischer Oberflächenwellenwandler nach einem der Ansprüche 1 und 2, **dadurch gekennzeichnet, daß** die Periodizität der Vertiefungen und Erhöhungen der charakteristischen Wellenlänge der Betriebsfrequenz des Wandlers gleicht.

8. Akustischer Oberflächenwellenwandler nach Anspruch 7, **dadurch gekennzeichnet, daß** er zwei ineinander verschachtelte Netze von Elektroden enthält, sodaß über die Länge einer charakteristischen Wellenlänge das erste Netz eine erste mit einer ersten Polarität verbundene Elektrode sowie das zweite Netz eine zweite und eine dritte mit einer zweiten Polarität verbundene Elektrode besitzt.

9. Akustischer Oberflächenwellenwandler nach Anspruch 7, **dadurch gekennzeichnet, daß** er ein erstes, ein zweites und ein drittes Netz von ineinander verschachtelten Elektroden besitzt, die an eine erste, beziehungsweise zweite, beziehungsweise dritte Polarität derart angeschlossen sind, daß über eine Strecke gleich einer charakteristischen Wellenlänge der Wandler nacheinander eine Elektrode des ersten Netzes, eine Elektrode des zweiten Netzes und eine Elektrode des dritten Netzes besitzt.
